# EUROPEAN PATENT APPLICATION

(11) **EP 4 517 809 A1**
(43) Date of publication of application: **05.03.2025**
(21) Application number: 23818976.5
(22) Date of filing: 30.05.2023
(51) Int. Cl.: H01L 23/29

(54) **SEMICONDUCTOR DEVICE AND MANUFACTURING METHOD THEREFOR**

(30) Priority: 07.06.2022 CN 202210634224
(71) Applicant: Huawei Technologies Co., Ltd., Shenzhen, Guangdong 518129 (CN)
(72) Inventor: SU, Shuai, Shenzhen, Guangdong 518129 (CN); FENG, Peng, Shenzhen, Guangdong 518129 (CN); HAN, Mingtao, Shenzhen, Guangdong 518129 (CN); LI, Haotian, Shenzhen, Guangdong 518129 (CN); HE, Linfeng, Shenzhen, Guangdong 518129 (CN); WU, Long, Shenzhen, Guangdong 518129 (CN); WEI, Wei, Shenzhen, Guangdong 518129 (CN); ZHANG, Yawen, Shenzhen, Guangdong 518129 (CN)
(74) Representative: Pfenning, Meinig & Partner mbB
(86) International application number: PCT/CN2023/097066
(87) International publication number: WO 2023/236811

(57) **Abstract**

This application provides a semiconductor component and a preparation method therefor. The semiconductor component may include a substrate, an epitaxial layer, a first dielectric layer, and a second dielectric layer that are sequentially stacked. The first dielectric layer may include a first material, and the second dielectric layer may include a second material. An element included in the first material may not be completely the same as an element included in the second material. The first material may include an aluminum element, and the second material may include a silicon element. In this way, insulation of the first dielectric layer can be improved, a static current of the semiconductor component can be reduced, and therefore static power consumption of the semiconductor component can be reduced. In the preparation method, a dry etching process and a wet corrosion process are combined to form a second groove used to deposit a gate. In this way, a depth of the second groove can be accurately controlled, thereby improving uniformity and a yield rate of the semiconductor component. In addition, damage to an interface of the second groove can be avoided, an interface state of the gate can be reduced, and gate leakage can be avoided, thereby improving reliability of the semiconductor component.

## Description

This application claims priority to Chinese Patent Application No. 202210634224.2, filed with the China National Intellectual Property Administration on June 7, 2022 and entitled "SEMICONDUCTOR COMPONENT AND PREPARATION METHOD THEREFOR", which is incorporated herein by reference in its entirety.

### TECHNICAL FIELD

This application relates to the field of semiconductor technologies, and in particular, to a semiconductor component, an electronic chip, an electronic device, and a preparation method for a semiconductor component.

### BACKGROUND

With development of science and technology, electronic chips including semiconductor components (such as a field-effect transistor) are widely used in electronic devices such as a mobile phone and a tablet computer. The semiconductor component may include a substrate, an epitaxial layer, a dielectric layer, and the like that are stacked. The substrate may include elements such as silicon, arsenic, and carbon, the epitaxial layer may include elements such as gallium, nitrogen, and aluminum, and the dielectric layer may include elements such as silicon, oxygen, and nitrogen. A material included in the dielectric layer determines insulation of the dielectric layer, and further affects static power consumption of the semiconductor component.

Therefore, how to reduce the static power consumption of the semiconductor component becomes a technical problem to be resolved urgently.

### SUMMARY

This application provides a semiconductor component, an electronic chip, an electronic device, and a preparation method for a semiconductor component, to improve insulation of a first dielectric layer, reduce a static current of the semiconductor component, and therefore reduce static power consumption of the semiconductor component.

According to a first aspect, this application provides a semiconductor component. The semiconductor component may include a substrate, an epitaxial layer, a first dielectric layer, and a second dielectric layer. The substrate, the epitaxial layer, the first dielectric layer, and the second dielectric layer may be sequentially stacked.

The first dielectric layer may include a first material, and the second dielectric layer may include a second material.

Further, an element included in the first material may not be completely the same as an element included in the second material. That is, the element included in the first material may be partially the same as or completely different from the element included in the second material.

Further, the first material may include an aluminum element, and the second material may include a silicon element.

In the semiconductor component provided in this application, the element included in the first material included in the first dielectric layer is not completely the same as the element included in the second material included in the second dielectric layer, the first dielectric layer includes the first material including the aluminum element, and the second dielectric layer includes the second material including the silicon element. This can increase a relative dielectric constant (which may also be referred to as relative permittivity) of the first dielectric layer, thereby improving insulation of the first dielectric layer, reducing a static current of the semiconductor component, and reducing static power consumption of the semiconductor component.

In a possible implementation, the first material may be aluminum oxide or aluminum nitride. The second material may be silicon oxide, silicon nitride, or silicon oxynitride. Certainly, the first material may alternatively be another material including an aluminum element, and the second material may alternatively be another material including a silicon element. This is not limited in this application.

In another possible implementation, based on that the first material includes the aluminum element, the second dielectric layer may not include the aluminum element. That is, the first dielectric layer may include the aluminum element, the second dielectric layer may include the silicon element, but the second dielectric layer may not include the aluminum element.

In still another possible implementation, a thickness of the first dielectric layer may be 5 nm to 30 nm. A thickness of the second dielectric layer may be 100 nm to 300 nm. Certainly, the thickness of the first dielectric layer and the thickness of the second dielectric layer each may be within another thickness range. This is not limited in this application.

In yet another possible implementation, an element included in a material included in the epitaxial layer may not be completely the same as an element included in a material included in the substrate. That is, the element included in the material included in the epitaxial layer may be partially or completely different from the element included in the material included in the substrate. Therefore, the epitaxial layer may be referred to as heteroepitaxy.

According to a second aspect, this application provides an electronic chip. The electronic chip may include a passive component and the semiconductor component provided in the first aspect and the possible implementations of the first aspect. The passive component may be electrically connected to the semiconductor component.

In a possible implementation, the passive component may include a resistor, a capacitor, and the like. The passive component is not limited in this application.

According to a third aspect, this application provides an electronic device. The electronic device may include a circuit board and the electronic chip provided in the second aspect and the possible implementation of the second aspect. The electronic chip may be disposed on the circuit board.

According to a fourth aspect, this application provides a preparation method for a semiconductor component. The semiconductor component may include a substrate, an epitaxial layer, a first dielectric layer, and a second dielectric layer that are sequentially stacked. The preparation method may include: performing photoetching on the second dielectric layer, to form a mask layer; etching the second dielectric layer based on the mask layer, and removing the mask layer, to form a first groove; and etching the first dielectric layer based on the first groove, to form a second groove.

The first dielectric layer may include a first material, and the second dielectric layer may include a second material.

Further, an element included in the first material may not be completely the same as an element included in the second material. That is, the element included in the first material may be partially the same as or completely different from the element included in the second material.

Further, the first material may include an aluminum element, and the second material may include a silicon element.

In a possible implementation, the performing photoetching on the second dielectric layer, to form a mask layer may include: coating a surface of the second dielectric layer with photoresist, and baking, based on preset baking temperature and preset baking time, the second dielectric layer coated with the photoresist; exposing the baked second dielectric layer based on preset exposure time; and developing the exposed second dielectric layer based on preset development time by using a developer, to form the mask layer.

Further, the photoresist may be positive photoresist or negative photoresist. For the positive photoresist, the photoresist in an exposure area may be dissolved, that is, the positive photoresist is developed in the exposure area. For the negative photoresist, the photoresist in a non-exposure area may be dissolved, that is, the negative photoresist is developed in the non-exposure area.

In an example, the preset baking temperature may be 90°C to 120°C, and the preset baking time may be 3 min to 5 min. Certainly, the preset baking temperature may alternatively be within another temperature range, and the preset baking time may alternatively be within another time range. This is not limited in this application.

In another example, the preset exposure time may be 100 ms to 300 ms, and the preset development time may be 40s to 70s. Certainly, the preset exposure time and the preset development time each may alternatively be within another time range. This is not limited in this application.

In still another example, the developer may be tetramethylammonium hydroxide. Certainly, the developer may alternatively be of another type. This is not limited in this application.

In a possible implementation, the etching the second dielectric layer based on the mask layer, and removing the mask layer, to form a first groove may include: etching the second dielectric layer based on the mask layer by using a dry etching process, to obtain the etched second dielectric layer; and removing the mask layer on the surface of the etched second dielectric layer by using a photoresist remover, to form the first groove. That is, the photoresist is used as the mask layer, and the second dielectric layer is etched by using the dry etching process. It can be learned that, in this application, the second dielectric layer is etched by using the dry etching process, to form the first groove.

It should be noted that a depth of the first groove is an etching depth of the second dielectric layer, and does not include a thickness of the mask layer on the surface of the etched second dielectric layer.

In this application, the second dielectric layer is etched by using the dry etching process, so that the depth of the first groove can be accurately controlled, thereby improving uniformity and a yield rate of the semiconductor component.

In a possible implementation, fluorine-based gas or chlorine-based gas may be selected, to etch the second dielectric layer by using the dry etching process.

The fluorine-based gas may be gas including a fluorine element, a carbon element, a sulfur element, and the like, such as sulfur hexafluoride, carbon tetrafluoride, trifluoromethane, hexafluoroethane, or perfluoropropane. The chlorine-based gas may be gas including a chlorine element, such as carbon tetrachloride, chlorine gas, or boron chloride.

Further, the dry etching process may be any one of a reactive ion etching (reactive ion etching, RIE) process (an RIE process for short), an inductively coupled plasma (inductively coupled plasma, ICP) etching process (an ICP process for short), an advanced oxide etching (advanced oxide etching, AOE) process (an AOE process for short), and the like. Certainly, the second dielectric layer may alternatively be etched by using another dry etching process. This is not limited in this application.

In a possible implementation, the mask layer on the surface of the etched second dielectric layer is removed by using the photoresist remover, and the mask layer on the surface of the etched second dielectric layer may be cleaned by using different photoresist removers, to form the first groove.

Further, the photoresist remover may include any one of acetone, isopropyl alcohol, ethanol absolute, and N-methylpyrrolidone. The photoresist remover may alternatively include a combination of at least two of acetone, isopropyl alcohol, ethanol absolute, and N-methylpyrrolidone.

It can be learned that the mask layer on the surface of the etched second dielectric layer is removed, so that impact on a corrosion rate and a corrosion depth of the first dielectric layer can be avoided, thereby improving reliability of the preparation method.

In a possible implementation, the etching the first dielectric layer based on the first groove, to form a second groove may include: etching the first dielectric layer based on the first groove by using a wet corrosion process, to form the second groove.

That is, the first dielectric layer at a bottom of the first groove is etched based on the first groove, to obtain the second groove.

It may be figured out that the depth of the first groove may be the etching depth of the second dielectric layer, and a depth of the second groove may be a sum of the etching depth of the second dielectric layer and the corrosion depth of the first dielectric layer. Therefore, the depth of the second groove may be greater than the depth of the first groove.

Further, the first dielectric layer may be etched based on the first groove and preset corrosion time by using a corrosion solution, to form the second groove. That is, in this application, the first dielectric layer may be etched by using the wet corrosion process, to form the second groove.

In an example, the corrosion solution includes any one of a solution prepared from sulfuric acid and hydrogen peroxide according to a preset ratio, a tetramethylammonium hydroxide solution, and a potassium hydroxide solution. Certainly, the corrosion solution may alternatively be another solution that can etch the first dielectric layer. This is not limited in this application.

In another example, the preset corrosion time may be 1 min to 20 min. Certainly, the preset corrosion time may alternatively be within another time range. This is not limited in this application.

In this application, the first dielectric layer is etched by using the wet corrosion process. In this way, damage to an interface of the second groove is avoided, an interface state of a gate (which means some discrete or continuous electronic energy states or energy bands whose energy values are in a band gap at an interface between the gate and the epitaxial layer) is reduced, and gate leakage is avoided, thereby improving reliability of the semiconductor component.

In a possible implementation, the first material may be aluminum oxide or aluminum nitride. The second material may be silicon oxide, silicon nitride, or silicon oxynitride. Certainly, the first material may alternatively be another material including an aluminum element, and the second material may alternatively be another material including a silicon element. This is not limited in this application.

In another possible implementation, based on that the first material includes the aluminum element, the second dielectric layer may not include the aluminum element. That is, the first dielectric layer may include the aluminum element, the second dielectric layer may include the silicon element, but the second dielectric layer may not include the aluminum element.

In still another possible implementation, a thickness of the first dielectric layer may be 5 nm to 30 nm. A thickness of the second dielectric layer may be 100 nm to 300 nm. Certainly, the thickness of the first dielectric layer and the thickness of the second dielectric layer each may be within another thickness range. This is not limited in this application.

In conclusion, according to the preparation method for a semiconductor component provided in this application, the dry etching process and the wet corrosion process are combined, the first groove is formed by using the dry etching process, and the second groove used to deposit the gate is formed by using the wet corrosion process. In this way, the depth of the first groove can be accurately controlled, thereby improving the uniformity and the yield rate of the semiconductor component. In addition, the damage to the interface of the second groove can be avoided, the interface state of the gate can be reduced, and the gate leakage can be avoided, thereby improving the reliability of the semiconductor component.

According to a fifth aspect, this application provides a preparation method for a semiconductor component. The semiconductor component may include a substrate, an epitaxial layer, a first dielectric layer, and a second dielectric layer that are sequentially stacked. The preparation method may include: forming the epitaxial layer on a surface of the substrate; forming the first dielectric layer on a surface of the epitaxial layer by using a first material; and forming the second dielectric layer on a surface of the first dielectric layer by using a second material.

The first dielectric layer may include the first material, and the second dielectric layer may include the second material.

Further, an element included in the first material may not be completely the same as an element included in the second material. That is, the element included in the first material may be partially the same as or completely different from the element included in the second material.

Further, the first material may include an aluminum element, and the second material may include a silicon element.

In a possible implementation, the first material may be aluminum oxide or aluminum nitride. The second material may be silicon oxide, silicon nitride, or silicon oxynitride. Certainly, the first material may alternatively be another material including an aluminum element, and the second material may alternatively be another material including a silicon element. This is not limited in this application.

In another possible implementation, based on that the first material includes the aluminum element, the second dielectric layer may not include the aluminum element. That is, the first dielectric layer may include the aluminum element, the second dielectric layer may include the silicon element, but the second dielectric layer may not include the aluminum element.

In still another possible implementation, a thickness of the first dielectric layer may be 5 nm to 30 nm. A thickness of the second dielectric layer may be 100 nm to 300 nm. Certainly, the thickness of the first dielectric layer and the thickness of the second dielectric layer each may be within another thickness range. This is not limited in this application.

It should be understood that the technical solutions in the second aspect to the fifth aspect of this application are consistent with the technical solutions in the first aspect of this application, beneficial effects achieved by the aspects and corresponding feasible implementations are similar, and details are not described again.

### BRIEF DESCRIPTION OF DRAWINGS

To describe technical solutions in this application or in a conventional technology more clearly, the following briefly describes accompanying drawings used in describing embodiments or the conventional technology. It is clear that the accompanying drawings in the following description show some embodiments of this application, and a person of ordinary skill in the art may still derive other drawings from these accompanying drawings without creative efforts.
FIG. 1 is a diagram of a structure of a semiconductor component 1 according to an embodiment of this application;
FIG. 2 is a diagram of a structure of a semiconductor component 1 according to an embodiment of this application;
FIG. 3 is a schematic flowchart of a process 100 according to an embodiment of this application;
FIG. 4 is a diagram of a structure of forming a mask layer 50 according to an embodiment of this application;
FIG. 5 is a diagram of a structure of forming a groove 401 according to an embodiment of this application;
FIG. 6 is a schematic flowchart of a process 200 according to an embodiment of this application;
FIG. 7 is a schematic flowchart of a process 300 according to an embodiment of this application; and
FIG. 8 is a schematic flowchart of a process 400 according to an embodiment of this application.

### DESCRIPTION OF EMBODIMENTS

The following describes technical solutions of this application with reference to accompanying drawings.

In this specification, embodiments, claims, and accompanying drawings of this application, the terms "first", "second", and the like are merely intended for distinguishing and description, and shall not be understood as indicating or implying relative importance, or indicating or implying a sequence. In addition, the terms "include", "have", and any variant thereof are intended to cover non-exclusive inclusion, for example, include a series of steps or units. A method, system, product, or device is not necessarily limited to those steps or units expressly listed, but may include other steps or units not expressly listed or inherent to such a process, method, product, or device.

It should be understood that in this application, "at least one (item)" means one or more, and "a plurality of" means two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "At least one item (piece) of the following" or a similar expression thereof means any combination of these items, including a singular item (piece) or any combination of plural items (pieces). For example, at least one item (piece) of a, b, or c may indicate: a, b, c, a and b, a and c, b and c, or a, b, and c, where a, b, and c may be singular or plural.

With development of science and technologies, electronic chips including semiconductor components (such as a field-effect transistor) are widely used in electronic devices such as a mobile phone and a tablet computer. The semiconductor component may include a substrate, an epitaxial layer, a dielectric layer, and the like that are stacked. The substrate may include elements such as silicon Si (silicon), arsenic As (arsenic), and carbon C (carbon). The epitaxial layer may include elements such as gallium Ga (gallium), nitrogen N (nitrogen), and aluminum Al (aluminum). The dielectric layer may include elements such as silicon, oxygen O (oxygen), and nitrogen. A material included in the dielectric layer determines insulation of the dielectric layer, and further affects static power consumption of the semiconductor component.

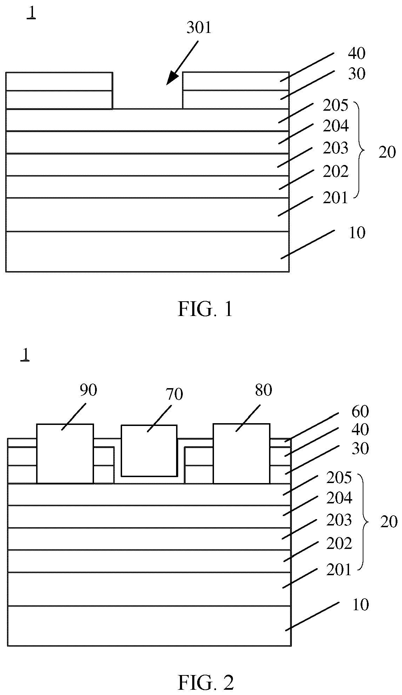

Therefore, to reduce the static power consumption of the semiconductor component, an embodiment of this application provides a semiconductor component, as shown in FIG. 1. The semiconductor component 1 may include a substrate 10, an epitaxial layer 20, a dielectric layer 30 (namely a first dielectric layer), and a dielectric layer 40 (namely a second dielectric layer). The substrate 10, the epitaxial layer 20, the dielectric layer 30, and the dielectric layer 40 may be sequentially stacked.

The dielectric layer 30 may include a material A (namely a first material), and the dielectric layer 40 may include a material B (namely a second material).

Further, an element included in the material A may not be completely the same as an element included in the material B. That is, the element included in the material A may be partially the same as or completely different from the element included in the material B.

Further, the material A may include an aluminum element, and the material B may include a silicon element.

In the semiconductor component 1 provided in this application, the element included in the material A included in the dielectric layer 30 is not completely the same as the element included in the material B included in the dielectric layer 40. The dielectric layer 30 includes the material A including the aluminum element, so that a relative dielectric constant of the dielectric layer 30 can be increased, thereby improving insulation of the dielectric layer 30, reducing a static current of the semiconductor component 1, and reducing static power consumption of the semiconductor component 1. The dielectric layer 40 includes the material B including the silicon element.

In an example, as shown in FIG. 1, a groove 301 (namely a second groove) may be provided on each of the dielectric layer 30 and the dielectric layer 40. A depth of the groove 301 may be a sum of a thickness of the dielectric layer 30 (namely an etching depth of the dielectric layer 30 below) and a thickness of the dielectric layer 40 (namely a corrosion depth of the dielectric layer 40 below). The groove 301 is used to form a gate of the semiconductor component 1. Refer to the following descriptions.

In another example, an element included in a material included in the epitaxial layer 20 may not be completely the same as an element included in a material included in the substrate 10. That is, the element included in the material included in the epitaxial layer 20 may be partially or completely different from the element included in the material included in the substrate 10. Therefore, the epitaxial layer 20 may be referred to as heteroepitaxy.

Further, the epitaxial layer 20 may include a buffer layer 201, a channel layer 202, an insertion layer 203, a barrier layer 204, and a cap layer 205 that are sequentially stacked. The buffer layer 201 is in contact with the substrate 10, and the cap layer 205 is in contact with the dielectric layer 30.

Further, the substrate 10 may include silicon, silicon carbide SiC (silicon carbide), sapphire (sapphire), and the like. The buffer layer 201 may include a material like gallium nitride GaN (gallium nitride) or aluminum nitride AlN (aluminum nitride). The channel layer 202 may include a material like the gallium nitride GaN. The insertion layer 203 may include a material like the aluminum nitride AlN. The barrier layer 204 may include a material like aluminum gallium nitride AlGaN (aluminum gallium nitride) or indium aluminum nitride InAlN (indium aluminum nitride). The cap layer 205 may include a material like the gallium nitride GaN. Certainly, the buffer layer 201, the channel layer 202, the insertion layer 203, the barrier layer 204, and the cap layer 205 each may alternatively include another material. This is not limited in this embodiment of this application.

In this embodiment of this application, the substrate 10 may include the silicon Si, the buffer layer 201, the channel layer 202, and the cap layer 205 may include the gallium nitride GaN, the insertion layer 203 may include the aluminum nitride AlN, and the barrier layer 204 may include the aluminum gallium nitride AlGaN. Therefore, the element included in the material included in the epitaxial layer 20 is completely different from the element included in the material included in the substrate 10. The epitaxial layer 20 in this embodiment of this application is the heteroepitaxy.

In a possible implementation, the semiconductor component 1 may further include a gate dielectric layer 60, a source 90, a gate 70, and a drain 80, as shown in FIG. 2.

The gate dielectric layer 60 may be stacked on a surface of the dielectric layer 40 and inside the groove 301. The gate 70 may be disposed on a surface of the gate dielectric layer 60. The source 90 and the drain 80 may also be disposed on the surface of the gate dielectric layer 60. The source 90 may pass through the dielectric layer 30 and the dielectric layer 40 to be in contact with the cap layer 205. Similarly, the drain 80 may also pass through the dielectric layer 30 and the dielectric layer 40 to be in contact with the cap layer 205. Therefore, ohmic contact may be formed between the source 90 and the cap layer 205, and ohmic contact may also be formed between the drain 80 and the cap layer 205.

In another possible implementation, the material A may be aluminum oxide or aluminum nitride. The material B may be silicon oxide, silicon nitride, or silicon oxynitride. Certainly, the material A may alternatively be another material including the aluminum element, and the material B may alternatively be another material including the silicon element. This is not limited in this application.

In still another possible implementation, based on that the material A includes the aluminum element, the dielectric layer 40 may not include the aluminum element. That is, the dielectric layer 30 may include the aluminum element, the dielectric layer 40 may include the silicon element, but the dielectric layer 40 may not include the aluminum element.

In this embodiment of this application, the dielectric layer 30 may include aluminum oxide Al₂O₃ (aluminum oxide), and the dielectric layer 40 may include silicon dioxide SiO₂.

In still another possible implementation, the thickness of the dielectric layer 30 may be 5 nm to 30 nm. The thickness of the dielectric layer 40 may be 100 nm to 300 nm. Certainly, the dielectric layer 30 and the dielectric layer 40 each may be within another thickness range. This is not limited in this application.

In this embodiment of this application, the thickness of the dielectric layer 30 may be 25 nm, and the thickness of the dielectric layer 40 may be 200 nm.

The semiconductor component 1 provided in this embodiment of this application may be a field-effect transistor, and may further be a high electron mobility transistor (high electron mobility transistor, HEMT), a heterojunction field effect transistor (heterojunction field effect transistor, HFET), or a modulation-doped field-effect transistor (modulation-doped FET, MODFET). The HEMT is used as an example for description in this embodiment of this application.

An embodiment of this application further provides an electronic chip. The electronic chip may include a passive component and a semiconductor component 1. The passive component may be electrically connected to the semiconductor component 1.

In a possible implementation, the passive component may include a resistor, a capacitor, and the like. The passive component is not limited in this embodiment of this application.

An embodiment of this application further provides an electronic device. The electronic device may include a circuit board and the foregoing electronic chip. The electronic chip may be disposed on the circuit board.

An embodiment of this application provides a preparation method for a semiconductor component. For related descriptions of the semiconductor component, refer to the foregoing descriptions. Details are not described in this embodiment of this application again.

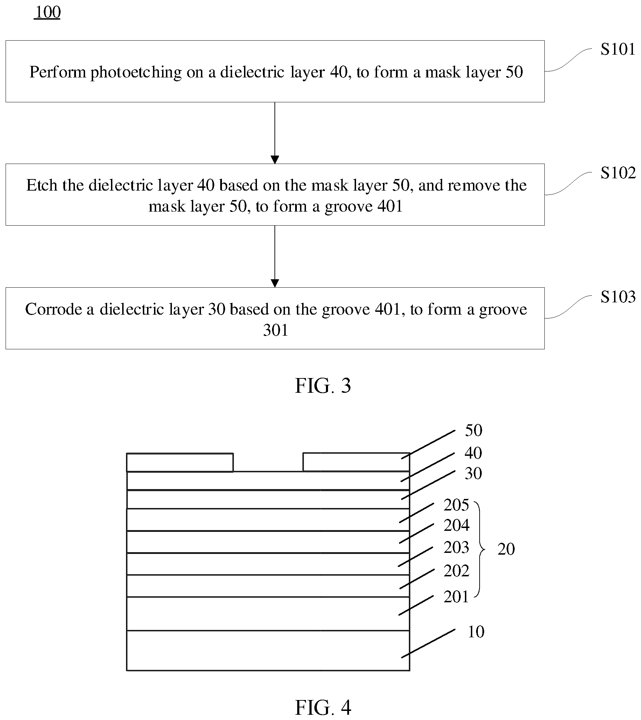

As shown in FIG. 3, a process 100 may be implemented based on the following steps.

Step S101: Perform photoetching on a dielectric layer 40, to form a mask layer 50, as shown in FIG. 4.

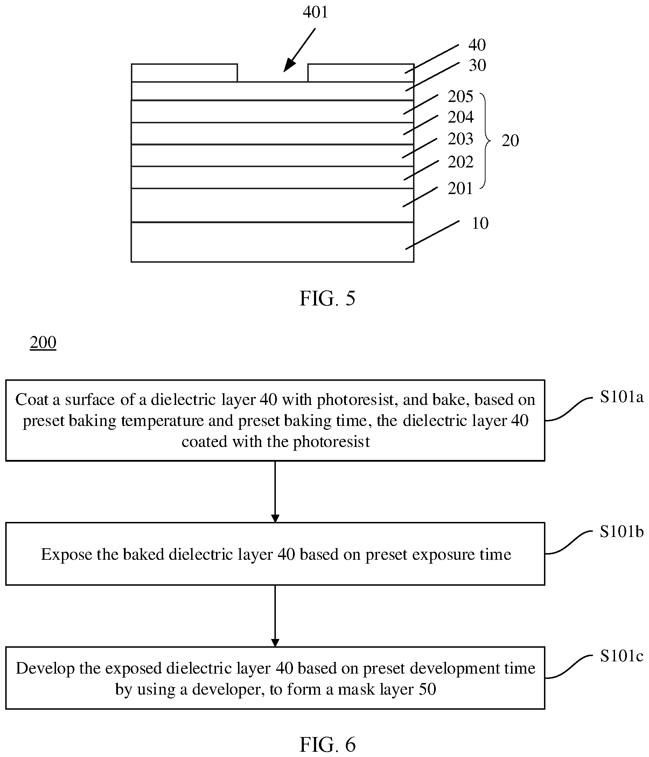

Step S102: Etch the dielectric layer 40 based on the mask layer 50, and remove the mask layer 50, to form a groove 401, as shown in FIG. 5. It can be learned from FIG. 5 that a depth of the groove 401 may be an etching depth of the dielectric layer 40, and does not include a thickness of the mask layer 50 on a surface of the etched dielectric layer 40, that is, does not include the thickness of the mask layer 50 in FIG. 4.

Step S103: Etch a dielectric layer 30 based on the groove 401, to form a groove 301, as shown in FIG. 1.

In a possible implementation, in a process 200 shown in FIG. 6, step S101 may be implemented based on the following steps.

Step S101a: Coat the surface of the dielectric layer 40 with photoresist, and bake, based on preset baking temperature and preset baking time, the dielectric layer 40 coated with the photoresist.

In an example, the photoresist may be positive photoresist or negative photoresist. For the positive photoresist, the photoresist in an exposure area may be dissolved, that is, the positive photoresist is developed in the exposure area. For the negative photoresist, the photoresist in a non-exposure area may be dissolved, that is, the negative photoresist is developed in the non-exposure area. In this embodiment of this application, the surface of the dielectric layer 40 is coated with the positive photoresist.

In another example, the preset baking temperature may be 90°C to 120°C, and the preset baking time may be 3 min to 5 min. Certainly, the preset baking temperature may alternatively be within another temperature range, and the preset baking time may alternatively be within another time range. This is not limited in this application. In this embodiment of this application, the preset baking temperature may be 100°C, and the preset baking time may be 4 min.

Step S101b: Expose the baked dielectric layer 40 based on preset exposure time.

For example, the preset exposure time may be 100 ms to 300 ms. Certainly, the preset exposure time may alternatively be within another time range. This is not limited in this application. In this embodiment of this application, the preset exposure time may be 110 ms.

Step S101c: Develop the exposed dielectric layer 40 based on preset development time by using a developer, to form the mask layer 50, as shown in FIG. 4.

In an example, the preset development time may be 40s to 70s. Certainly, the preset development time may alternatively be within another time range. This is not limited in this application. In this embodiment of this application, the preset development time may be 50s.

In another example, the developer may be tetramethylammonium hydroxide C₄H₁₃NO (tetramethylammonium hydroxide). Certainly, the developer may alternatively be of another type. This is not limited in this application.

A related process of forming the mask layer 50 is described above. Certainly, the mask layer 50 may alternatively be formed in another manner. This is not limited in this embodiment of this application.

In a dry etching process, reactive gas (such as a reactive ion (reactive ion, RI), inductively coupled plasma (inductively coupled plasma, ICP), or an ion beam (ion beam, IB)) is usually used, and a radio frequency voltage is applied, to generate ions and electrons. The ions and electrons may physically bombard a surface of a dielectric layer, and a chemical reaction occurs between the reactive gas and the dielectric layer, so that the dielectric layer can be etched.

Therefore, in step S102, the photoresist may be used as the mask layer 50, and the dielectric layer 40 is etched by using the dry etching process.

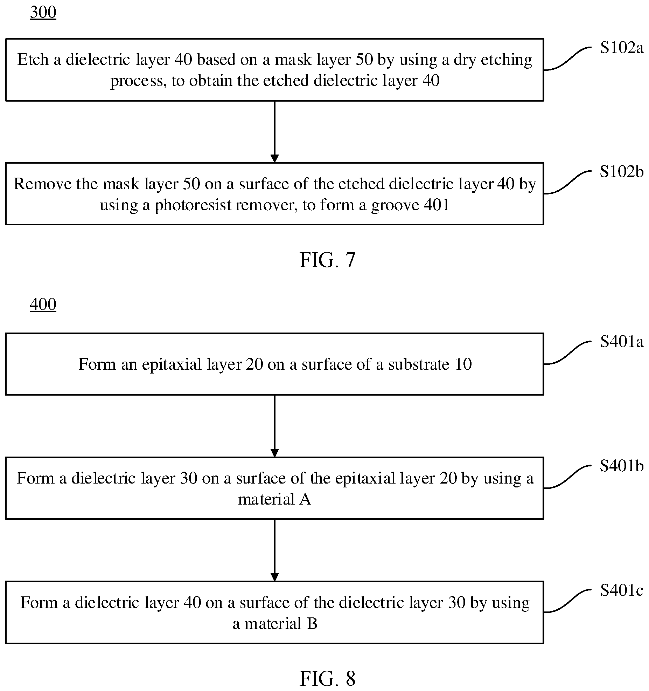

In an implementation, in a process 300 shown in FIG. 7, step S102 may be implemented based on the following steps.

Step S102a: Etch the dielectric layer 40 based on the mask layer 50 by using the dry etching process, to obtain the etched dielectric layer 40.

Step S102b: Remove the mask layer 50 on the surface of the etched dielectric layer 40 by using a photoresist remover, to form the groove 401, as shown in FIG. 5. In an example, in step S102a, fluorine-based gas or chlorine-based gas may be selected, to etch the dielectric layer 40 using the dry etching process based on preset etching time.

In an example, the fluorine-based gas may be gas including a fluorine element, a carbon element, a sulfur element, and the like, such as sulfur hexafluoride, carbon tetrafluoride, trifluoromethane, hexafluoroethane, or perfluoropropane. The chlorine-based gas may be gas including a chlorine element, such as carbon tetrachloride, chlorine gas, or boron chloride.

In another example, the etching time may be a ratio of a thickness of the dielectric layer 40 to an etching rate.

In still another example, the dry etching process may be any one of a reactive ion etching (reactive ion etching, RIE) process (an RIE process for short), an inductively coupled plasma (inductively coupled plasma, ICP) etching process (an ICP process for short), an advanced oxide etching (advanced oxide etching, AOE) process (an AOE process for short), and the like. Certainly, the dielectric layer 40 may alternatively be etched by using another dry etching process. This is not limited in this application.

In this embodiment of this application, the carbon tetrafluoride is selected, to etch the dielectric layer 40 by using the AOE process. The etching time is 1 min, and the etching depth of the dielectric layer 40 is 210 nm. It may be understood that the depth of the groove 401 is 210 nm.

In another example, in step S102b, the mask layer 50 on the surface of the etched dielectric layer 40 may be cleaned by using different photoresist removers, to form the groove 401.

Further, the photoresist remover may include any one of acetone CH₃COCH₃ (acetone), isopropyl alcohol C₃H₈O (isopropyl alcohol, IPA), ethanol absolute C₂H₆O (ethanol absolute), and N-methylpyrrolidone C₅H₉NO (N-methylpyrrolidone). The photoresist remover may alternatively include a combination of at least two of acetone, isopropyl alcohol, ethanol absolute, and N-methylpyrrolidone. In this embodiment of this application, the mask layer 50 on the surface of the etched dielectric layer 40 is cleaned by using the acetone and the isopropyl alcohol.

It can be learned that the mask layer 50 on the surface of the etched dielectric layer 40 is removed, so that impact on a corrosion rate and a corrosion depth of the dielectric layer 30 can be avoided, thereby improving reliability of the preparation method.

A related process of forming the groove 401 is described above. Certainly, the groove 401 may alternatively be formed in another manner. This is not limited in this embodiment of this application.

In this embodiment of this application, the dielectric layer 40 is etched by using the dry etching process, so that the depth of the groove 401 can be accurately controlled, thereby improving uniformity and a yield rate of the semiconductor component 1.

A wet corrosion process is a process of etching a dielectric layer by using a corrosion solution. In step S103 in this embodiment of this application, the dielectric layer 30 may be etched based on the groove 401 and preset corrosion time by using a corrosion solution, to form the groove 301. That is, in this embodiment of this application, the groove 301 is formed by using the wet corrosion process, as shown in FIG. 1.

In an example, the corrosion solution may include any one of a solution prepared from sulfuric acid H₂SO₄ (sulfuric acid) and hydrogen peroxide H₂O₂ (hydrogen peroxide) according to a preset ratio, a tetramethylammonium hydroxide C₄H₁₃NO (tetramethylammonium hydroxide, TMAH) solution, and a potassium hydroxide KOH (potassium hydroxide) solution. Certainly, the corrosion solution may alternatively be another solution that can etch the dielectric layer 30. This is not limited in this embodiment of this application. In this embodiment of this application, the corrosion solution is the solution prepared from the sulfuric acid whose mass fraction is greater than or equal to 70% (namely concentrated sulfuric acid) and the hydrogen peroxide. The preset ratio is a volume ratio of the concentrated sulfuric acid to the hydrogen peroxide, and may be 7:3.

In another example, the preset corrosion time may be 1 min to 20 min. Certainly, the preset corrosion time may alternatively be within another time range. This is not limited in this application. In this embodiment of this application, the preset corrosion time may be 5 min.

A related process of forming the groove 301 is described above. Certainly, the groove 301 may alternatively be formed in another manner. This is not limited in this embodiment of this application.

In this application, the dielectric layer 30 is etched by using the wet corrosion process. In this way, damage to an interface of the groove 301 is avoided, an interface state of a gate (which means some discrete or continuous electronic energy states or energy bands whose energy values are in a band gap at an interface between the gate and the epitaxial layer) is reduced, and gate leakage is avoided, thereby improving reliability of the semiconductor component.

In conclusion, according to the preparation method for a semiconductor component provided in this embodiment of this application, the dry etching process and the wet corrosion process are combined, the groove 401 is formed by using the dry etching process, and the groove 301 used to deposit the gate is formed by using the wet corrosion process. In this way, the depth of the groove 401 can be accurately controlled, thereby improving the uniformity and the yield rate of the semiconductor component. In addition, the damage to the interface of the groove 301 can be avoided, the interface state of the gate can be reduced, and the gate leakage can be avoided, thereby improving the reliability of the semiconductor component.

In a possible implementation, in a process 400 shown in FIG. 8, before the foregoing process 100 is performed in the preparation method provided in this embodiment of this application, the dielectric layer 30 and the dielectric layer 40 may be further formed based on the following steps.

Step S401a: Form an epitaxial layer 20 on a surface of a substrate 10.

Step S401b: Form the dielectric layer 30 on a surface of the epitaxial layer 20 by using a material A.

Step S401c: Form the dielectric layer 40 on a surface of the dielectric layer 30 by using a material B.

For example, in step S401b, the dielectric layer 30 may be formed on the surface of the epitaxial layer 20 by using a deposition process. The deposition process may include an atomic layer deposition (atomic layer deposition, ALD) process (an ALD process for short), a plasma enhanced atomic layer deposition (plasma enhanced atomic layer deposition, PEALD) process (a PEALD process for short), a plasma enhanced chemical vapor deposition (plasma enhanced chemical vapor deposition, PECVD) process (a PECVD process for short), an inductively coupled plasma chemical vapor deposition (inductively coupled plasma chemical vapor deposition, ICPCVD) process (an ICPCVD process for short), a low pressure chemical vapor deposition (low pressure chemical vapor deposition, LPCVD) process (an LPCVD process for short), an electronic beam evaporation (electronic beam evaporation, EBE) process (an EBE process for short), a sputter deposition process, or the like.

In this embodiment of this application, the dielectric layer 30 is formed on the surface of the epitaxial layer 20 by using the PEALD process. The dielectric layer 30 may include aluminum oxide. A thickness of the dielectric layer 30 may be 25 nm.

For example, in step S401c, the dielectric layer 40 may be formed on the surface of the dielectric layer 30 by using the foregoing deposition process.

In this embodiment of this application, the dielectric layer 40 is formed on the surface of the dielectric layer 30 by using the PEALD process. The dielectric layer 40 may include silicon dioxide. The thickness of the dielectric layer 40 may be 200 nm.

It should be noted that a related process of forming the dielectric layer 30 and the dielectric layer 40 is described above. Certainly, the dielectric layer 30 and the dielectric layer 40 may alternatively be formed in another manner. This is not limited in this embodiment of this application.

It should be understood that, in embodiments of this application, sequence numbers of the foregoing processes do not mean execution sequences. The execution sequences of the processes should be determined based on functions and internal logic of the processes, and should not constitute any limitation on implementation processes of embodiments of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor component, comprising a substrate, an epitaxial layer, a first dielectric layer, and a second dielectric layer that are sequentially stacked, wherein
the first dielectric layer comprises a first material, and the second dielectric layer comprises a second material; and
an element comprised in the first material is not completely the same as an element comprised in the second material, the first material comprises an aluminum element, and the second material comprises a silicon element.

2. The semiconductor component according to claim 1, wherein the first material is aluminum oxide or aluminum nitride; and
the second material is silicon oxide, silicon nitride, or silicon oxynitride.

3. The semiconductor component according to claim 1 or 2, wherein the second material does not comprise the aluminum element.

4. The semiconductor component according to any one of claims 1 to 3, wherein a thickness of the first dielectric layer is 5 nm to 30 nm; and
a thickness of the second dielectric layer is 100 nm to 300 nm.

5. The semiconductor component according to any one of claims 1 to 4, wherein an element comprised in a material comprised in the epitaxial layer is not completely the same as an element comprised in a material comprised in the substrate.

6. A preparation method for a semiconductor component, wherein the semiconductor component comprises a substrate, an epitaxial layer, a first dielectric layer, and a second dielectric layer that are sequentially stacked, and the preparation method comprises:
performing photoetching on the second dielectric layer, to form a mask layer;
etching the second dielectric layer based on the mask layer, and removing the mask layer, to form a first groove; and
etching the first dielectric layer based on the first groove, to form a second groove, wherein
the first dielectric layer is configured with a first material, and the second dielectric layer is configured with a second material; and
an element comprised in the first material is not completely the same as an element comprised in the second material, the first material comprises an aluminum element, and the second material comprises a silicon element.

7. The preparation method according to claim 6, wherein the performing photoetching on the second dielectric layer, to form a mask layer comprises:
coating a surface of the second dielectric layer with photoresist, and baking, based on preset baking temperature and preset baking time, the second dielectric layer coated with the photoresist;
exposing the baked second dielectric layer based on preset exposure time; and
developing the exposed second dielectric layer based on preset development time by using a developer, to form the mask layer.

8. The preparation method according to claim 7, wherein the etching the second dielectric layer based on the mask layer, and removing the mask layer, to form a first groove comprises:
etching the second dielectric layer based on the mask layer by using a dry etching process, to obtain the etched second dielectric layer; and
removing the mask layer on the surface of the etched second dielectric layer by using a photoresist remover, to form the first groove.

9. The preparation method according to claim 7, wherein the dry etching process comprises any one of a reactive ion etching process, an inductively coupled plasma etching process, and an advanced oxide etching process; and
the photoresist remover comprises any one or more of acetone, isopropyl alcohol, ethanol absolute, and N-methylpyrrolidone.

10. The preparation method according to any one of claims 6 to 9, wherein the etching the first dielectric layer based on the first groove, to form a second groove comprises:
etching the first dielectric layer based on the first groove by using a wet corrosion process, to form the second groove, wherein a depth of the second groove is greater than a depth of the first groove.

11. The preparation method according to claim 10, wherein the etching the first dielectric layer based on the first groove by using a wet corrosion process, to form the second groove comprises:
etching the first dielectric layer based on the first groove and preset corrosion time by using a corrosion solution, to form the second groove.

12. The preparation method according to claim 11, wherein the corrosion solution comprises any one of a solution prepared from sulfuric acid and hydrogen peroxide according to a preset ratio, a tetramethylammonium hydroxide solution, and a potassium hydroxide solution.

13. The preparation method according to any one of claims 6 to 12, wherein the first material is aluminum oxide or aluminum nitride; and
the second material is silicon oxide, silicon nitride, or silicon oxynitride.

14. The preparation method according to any one of claims 6 to 13, wherein the second material does not comprise the aluminum element.

15. The preparation method according to any one of claims 6 to 14, wherein a thickness of the first dielectric layer is 5 nm to 30 nm; and
a thickness of the second dielectric layer is 100 nm to 300 nm.

16. A preparation method for a semiconductor component, wherein the semiconductor component comprises a substrate, an epitaxial layer, a first dielectric layer, and a second dielectric layer that are sequentially stacked, and the preparation method comprises:
forming the epitaxial layer on a surface of the substrate;
forming the first dielectric layer on a surface of the epitaxial layer by using a first material; and
forming the second dielectric layer on a surface of the first dielectric layer by using a second material, wherein
an element comprised in the first material is not completely the same as an element comprised in the second material, the first material comprises an aluminum element, and the second material comprises a silicon element.

17. The preparation method according to claim 16, wherein the first material is aluminum oxide or aluminum nitride; and
the second material is silicon oxide, silicon nitride, or silicon oxynitride.

18. The preparation method according to claim 16 or 17, wherein the second material does not comprise the aluminum element.

19. The preparation method according to any one of claims 16 to 18, wherein a thickness of the first dielectric layer is 5 nm to 30 nm; and
a thickness of the second dielectric layer is 100 nm to 300 nm.

20. An electronic chip, comprising a passive component and the semiconductor component according to any one of claims 1 to 5 that is electrically connected to the passive component.

21. An electronic device, comprising a circuit board and the electronic chip according to claim 20 that is disposed on the circuit board.
